# EUROPÄISCHE PATENTSCHRIFT

(11) **EP 2 289 113 B1**
(45) Veröffentlichungstag und Bekanntmachung des Hinweises auf die Patenterteilung: **08.04.2020**
(21) Anmeldenummer: 09757123.6
(22) Anmeldetag: 03.06.2009
(51) Int. Cl.: H01L 33/20, H01L 33/40, H01L 33/00

(54) **OPTOELEKTRONISCHES BAUELEMENT UND VERFAHREN ZU DESSEN HERSTELLUNG**
OPTOELECTRONIC COMPONENT AND METHOD FOR THE PRODUCTION THEREOF
COMPOSANT OPTOÉLECTRONIQUE ET SON PROCÉDÉ DE PRODUCTION

(30) Priorität: 06.06.2008 DE 102008027041; 06.10.2008 DE 102008050538
(43) Veröffentlichungstag der Anmeldung: 02.03.2011
(73) Patentinhaber: OSRAM Opto Semiconductors GmbH, 93055 Regensburg (DE)
(72) Erfinder: KAISER, Stephan, 93049 Regensburg (DE); PLÖSSL, Andreas, 93051 Regensburg (DE)
(74) Vertreter: Epping - Hermann - Fischer
(86) Internationale Anmeldenummer: PCT/DE2009/000781
(87) Internationale Veröffentlichungsnummer: WO 2009/146689

(56) Entgegenhaltungen:
- US-A1- 2004 104 390
- US-A1- 2006 186 418

## Beschreibung

Es wird ein optoelektronisches Bauelement sowie ein Verfahren zu dessen Herstellung nach dem Anspruch 1 angegeben.
Ein weit verbreitetes Problem bei der Herstellung von optoelektronischen Bauelementen ist, dass nach dem epitaktischen Aufwachsen der Halbleiterschicht auf einem Aufwachssubstrat mehrere Fotolithografieschritte p-seitig, also von der Seite, die später mit dem p-Kontakt versehen wird, durchgeführt werden müssen, bevor beispielsweise per Laser-Lift-Off (LLO) das Aufwachssubstrat von der Epitaxieschicht getrennt wird.
Beim Laser-Lift-Off (LLO) wird das Substrat, welches von den anderen Schichten abgelöst werden soll, mit einem gepulsten oder nicht gepulsten Laser bestrahlt, welcher das Substrat durchdringt. Dadurch kommt es zur Erwärmung der Oberfläche der Halbleiterschicht, welche an das Substrat anschließt. Ist die nötige Temperatur erreicht kommt es zur Abspaltung des Substrates.

Ein Trennverfahren von Substrat und Halbleiterschicht mittels Laser-Lift-Off ist beispielsweise in der DE 19640594 A1 erläutert, deren Offenbarungsgehalt insofern hiermit durch Rückbezug aufgenommen wird. Verfahrensschritte vor dem LLO können im Folgenden als "prä-LLO" bezeichnet werden, die danach als "post-LLO".

In der Halbleiterfertigung bezeichnet man mit "Mesa" einen geschützten, nach einem Ätzschritt erhöhten Bereich. Die durch den Ätzprozess entstandenen Vertiefungen werden als "Mesagräben" bezeichnet, die Seitenwände der Mesagräben als "Mesaflanken". Jedem Ätzschritt geht für gewöhnlich ein Fotolithografieschritt voran, bei dem mittels eines Fotolackes der Bereich, der später die Mesa ausbilden soll, vor der Ätzchemikalie geschützt wird. Hierzu wird zuerst die gesamte Oberfläche mit einem Fotolack beschichtet, anschließend eine Maske auf den Lack gelegt und die nicht durch die Maske abgedeckten Bereiche belichtet. Durch das Belichten härten diese Teilbereiche des Lackes aus, wohingegen die nichtbelichteten Bereiche im nächsten Schritt herausgewaschen werden können. Die nicht durch den ausgehärteten Fotolack geschützten Bereiche können in einem weiteren Verfahrensschritt geätzt werden.

Bei einer verbreiteten Herstellungsmethode sind hierbei vier Fotolithografieschritte vor dem LLO durchzuführen. Einer davon umfasst das GaN-Mesa-Ätzen von der p-Seite, während die n-Seite mit dem Aufwachssubstrat verbunden ist. Nach dem Ablösen des Aufwachssubstrats per LLO ist in der Regel ein weiterer Fotolithografieschritt notwendig um die n-Kontaktstruktur zu formen.

Die Druckschrift US 2004/0104390 A1 beschreibt ein Halbleiterbauelement umfassend ein Substrat, eine leitende Schicht sowie eine Halbleiterschicht. Zwischen der Halbleiterschicht und der leitenden Schicht ist eine isolierende Schicht angeordnet, die einen ersten Kontakt umschließt. Das Bauelement weist auf der Oberseite noch einen zweiten Kontakt auf. Zwischen der isolierenden Schicht und der leitenden Schicht kann eine plane reflektierende Schicht angeordnet sein, die nicht im Kontakt zur Halbleiterschicht steht. In der Halbleiterschicht können durch einen Ätzschritt Auskopplungsstrukturen erzeugt werden.

Die Druckschrift US 2006/0186418 A1 beschreibt eine Licht emittierende Diode. Bei einer Schichtenfolge bestehend aus einem Trägersubstrat, einer Metallschicht, einer Licht emittierenden aktiven Schicht und einem Substrat kann das Substrat entfernt werden.

Eine Aufgabe des erfindungsgemäßen Verfahrens besteht darin, die Anzahl der Fotolithografieschritte und Ätzschritte im Herstellungsverfahren gegenüber herkömmlichen Verfahren zu reduzieren und somit die Anzahl der Prozessschritte herabzusetzen.

Eine weitere Aufgabe besteht darin, die Mesa-Flankenschädigung beim Laser-Lift-Off (LLO) zu vermeiden.

Die Aufgaben werden durch Herstellungsverfahren nach dem Anspruch 1 gelöst.

Weiter erfindungsgemäße Verfahrensvarianten sowie Ausführungsformen des optoelektronischen Bauelements sind Gegenstand weiterer Patentansprüche.

Es sei an dieser Stelle darauf hingewiesen, dass mit dem Begriff "Bauelement" nicht nur fertige Bauelemente wie beispielsweise Leuchtdioden (LEDs) oder Laserdioden gemeint sind, sondern auch Substrate und/oder Halbleiterschichten, so dass ein erstes Bauelement und ein zweites Bauelement verbunden durch beispielsweise eine Klebstoff- oder Lotschicht ein übergeordnetes drittes Bauelement bilden bzw.

Teil eines solchen sind. Die Verbindung zweier Bauelemente miteinander ist beispielsweise bei der Herstellung eines Dünnfilm-Halbleiterchips zweckmäßig.

Bei dem optoelektronischen Bauelement kann es sich beispielsweise um einen Dünnfilm-Leuchtdiodenchip handeln.
Ein Dünnfilm-Leuchtdiodenchip zeichnet sich durch mindestens eines der folgenden charakteristischen Merkmale aus:
- an einer zu einem Trägerelement, insbesondere dem Trägersubstrat, hingewandten Hauptfläche der strahlungserzeugenden Halbleiterschichtenfolge, bei der es sich insbesondere um eine strahlungserzeugende Epitaxie-Schichtenfolge handelt, ist eine reflektierende Schicht aufgebracht oder ausgebildet, die zumindest einen Teil der in der Halbleiterschichtenfolge erzeugten elektromagnetischen Strahlung in diese zurückreflektiert;
- der Dünnfilm-Leuchtdiodenchip weist ein Trägerelement auf, bei dem es sich nicht um das Aufwachssubstrat handelt, auf dem die Halbleiterschichtenfolge epitaktisch gewachsen wurde, sondern um ein separates Trägerelement, das nachträglich an der Halbleiterschichtenfolge befestigt wurde;
- die Halbleiterschichtenfolge weist eine Dicke im Bereich von 20 µm oder weniger, insbesondere im Bereich von 10 µm oder weniger auf;
- die Halbleiterschichtenfolge ist frei von einem Aufwachssubstrat. Vorliegend bedeutet "frei von einem Aufwachssubstrat, dass ein gegebenenfalls zum Aufwachsen benutztes Aufwachssubstrat von der Halbleiterschichtenfolge entfernt oder zumindest stark gedünnt ist. Insbesondere ist es derart gedünnt, dass es für sich oder zusammen mit der Epitaxie-Schichtenfolge alleine nicht freitragend ist. Der verbleibende Rest des stark gedünnten Aufwachssubstrats ist insbesondere als solches für die Funktion eines Aufwachssubstrates ungeeignet; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.

Ein Grundprinzip eines Dünnfilm-Leuchtdiodenchips ist beispielsweise in der Druckschrift I. Schnitzer et al., Appl. Phys. Lett. 63 (16) 18. Oktober 1993, Seiten 2174 - 2176 beschrieben, deren Offenbarungsgehalt insofern hiermit durch Rückbezug aufgenommen wird. Beispiele für Dünnfilm-Leuchtdiodenchips sind in den Druckschriften EP 0905797 A2 und WO 02/13281 A1 beschrieben, deren Offenbarungsgehalt insofern hiermit ebenfalls durch Rückbezug aufgenommen wird.

Die Erfindung wird durch die Ansprüche definiert. Gegenstände, die nicht unter die Ansprüche fallen, sind nicht Teil der Erfindung.

Ein erfindungsgemäßes Verfahren zur Herstellung eines optoelektronischen Bauelements umfasst die folgenden Verfahrensschritte: Bereitstellen eines Aufwachssubstrates als Verfahrensschritt A), epitaktisches Aufwachsen zumindest einer Halbleiterschicht zur Erzeugung einer im Betrieb aktiven Zone auf das Aufwachssubstrat als Verfahrensschritt B) Aufbringen eines niedrigbrechenden Dielektrikums auf die Halbleiterschicht und Entfernen von Teilbereichen des niedrigbrechenden Dielektrikums als Verfahrensschritt B1). Als weitere Verfahrensschritte umfasst das Verfahren das Aufbringen einer metallischen Spiegelschicht auf die Halbleiterschicht und das niedrigbrechende Dielektrikum, sodass die metallische Spiegelschicht in den Teilbereichen das niedrig brechende Dielektrikum durchdringt, als Verfahrensschritt C), das Aufbringen einer Diffusionsbarriereschicht auf der metallischen Spiegelschicht, das Aufbringen einer Passivierungsschicht auf der Diffusionsbarriereschicht und das Aufbringen zumindest einer Kontaktschicht zur elektrischen Kontaktierung des Bauelements als Verfahrensschritt D). Des Weiteren umfasst das Verfahren das Abtrennen des Aufwachssubstrates von der Halbleiterschicht als Verfahrenschritt E), wobei eine Oberfläche der Halbleiterschicht freigelegt wird. Die Halbleiterschicht wird anschließend im Verfahrensschritt F) mittels eines Ätzverfahrens von seitens der Oberfläche, die im Verfahrensschritt E) freigelegt wurde, strukturiert, so dass die Halbleiterschicht Mesagräben mit einer positiven Mesaflanke aufweist, wobei sich die Mesagräben von der Seite der Oberfläche zur Spiegelschicht hin verengen.

Bei einer Verfahrensvariante ist zur Herstellung des strukturierten Schichtenfolge nur ein Ätzschritt und somit auch nur ein Fotolithografieschritt notwendig. Dies stellt einen deutlichen Vorteil gegenüber den herkömmlichen Verfahrensmethoden dar. Die Prozessrisiken können dadurch reduziert und die Ausbeute gesteigert werden. Des Weiteren wird der gesamte Herstellungsablauf beschleunigt.

Dadurch, dass das Ätzen im Verfahrenschritt F) von der Seite der Oberfläche erfolgt, die im Verfahrensschritt E) freigelegt wurde, liegt eine positive Mesakante vor. Das bedeutet, dass sich die Mesagräben, welche durch den Ätzprozess entstanden sind, von der Oberfläche die zuvor mit dem Aufwachssubstrat verbunden war her betrachtet zu den anderen Schichten hin verengen, die Mesa selbst, also beispielsweise die Halbleiterschicht, verbreitert sich hingegen von der Oberfläche her betrachtet. Die Flanken der Gräben sind also leicht schräg und verlaufen nicht senkrecht zur Oberfläche, was eine Folge des Nass-Ätz-Verfahrens ist. Das Ätzen so wie die damit verbundene Fototechnik finden erst nach dem LLO statt, es handelt sich also um eine sogenannte post-LLO-Mesa-Fototechnik.

Durch die positive Mesakante sind des Weiteren geringfügige Verbesserungen der Lichtabstrahlung möglich.
Bei den bisherigen Techniken wurde eine prä-LLO-Mesa-Fototechnik durchgeführt, welche von der Seite erfolgte, welche von dem Substrat abgewandt ist. Dies hat zur Folge, dass die Mesaflanke nach hinten geneigt ist, also eine negative Mesakante vorliegt, d.h. eine prä-LLO-Mesa-Fototechnik führt zu einem Mesakantenunterschnitt. Dies kann zum Bruch der Spitzen der Mesakante beim LLO führen, die bei einer negativen Mesakante einen spitzen Winkel aufweisen.

Die positive Mesakante hat des Weiteren den Vorteil, dass sie gegenüber der negativen Mesakante an der Oberseite die mit dem Aufwachssubstrat verbunden war, eine höhere Stabilität und Bruchfestigkeit aufweist. Dies stellt für weitere Verfahrensschritte einen Vorteil dar. Eine Beschädigung der Mesaflanken beim LLO kann bei den erfindungsgemäßen Verfahrensvarianten nicht erfolgen, da hier erst der LLO erfolgt und erst im Anschluss daran das Ätzen der Mesagräben.

In einem weiteren erfindungsgemäßen Verfahren wird die metallische Spiegelschicht in Verfahrensschritt C) auf die unstrukturierte Halbleiterschicht aufgebracht.

Dies hat den Vorteil, dass die Spiegelschicht sich vollständig auf der Oberfläche der Halbleiterschicht befindet und kein Material in vorhandene Zwischenräume aufgebracht wird, welches in späteren Verfahrensschritten wieder entfernt werden müsste. Ein weiterer Vorteil besteht darin, dass die Halbleiterschicht und die Spiegelschicht zusammen in einem Ätzschritt strukturiert werden können. Gleiches gilt auch für weitere Schichten, die auf die Spiegelschicht aufgebracht werden und ebenfalls strukturiert werden sollen.

In einer weiteren Ausführungsform des Verfahrens wird im Verfahrensschritt B) genau eine Halbleiterschicht aufgewachsen. Das so hergestellte optoelektronische Bauelement umfasst somit nur eine Halbleiterschicht, was die Herstellung von sehr dünnen Bauelementen ermöglicht.

Als Material für die Halbleiterschicht, welches im Verfahrensschritt B) epitaktisch aufgewachsen wird, kann ein Material verwendet werden, welches ein III-V-Halbleitermaterial umfasst. Dieses III-V-Halbleitermaterial ist vorzugsweise GaN, GaInN oder AlN. Die Halbleiterschicht kann aber auch aus verschiedenen Materialien aufgebaut sein, welch durch nach einander epitaktisches Aufwachsen erzeugt sein können. Die Halbleiterschichten können beispielsweise undotiert, p- oder n-dotiert sein.

In einer weiteren Variante des erfindungsgemäßen Verfahrens wird die zumindest eine Kontaktschicht im Verfahrensschritt D) auf eine unstrukturierte Spiegelschicht aufgebracht. Dies hat wiederum den Vorteil, dass das Material der Kontaktschicht nicht auf bereits erzeugte Strukturen aufgebracht werden muss, und somit nicht in freigelegten Zwischenräumen eindringen kann und in weiteren Verfahrensschritten wieder entfernt werden muss. Auch kann hier die Strukturierung der Kontaktschicht falls notwendig zusammen mit der Strukturierung der Halbleiterschicht und Spiegelschicht erfolgen.

Das Abtrennen des Aufwachssubstrates von der Halbleiterschicht im Verfahrensschritt E) erfolgt vorzugsweise mittels Laser-Lift-Off (LLO).

In einer weiteren Ausführungsform des Verfahrens wird die Halbleiterschicht durch das Strukturieren im Verfahrensschritt F) durch Gräben in mehrere Teilbereiche unterteilt. Hierdurch wird eine Mesa-Struktur ausgebildet. Das bedeutet, dass die beispielsweise durch ein Ätzverfahren erzeugten Gräben die gesamte Halbleiterschicht durchdringen. Da die Gräben durch ein Strukturierungsverfahren erzeugt werden, welches von der Seite angewandt wird, die zuvor mit dem Aufwachssubstrat verbunden war, wird der Querschnitt der Gräben von der Oberfläche die beispielsweise durch den Laser-Lift-Off freigelegt wurde, in Richtung Spiegelschicht verengt. Die Halbleiterschicht weist dadurch an den Flanken eine positive Mesakante auf. Eine solche Halbleiterschicht zeichnet sich durch eine höhere Stabilität gegenüber einer Halbleiterschicht mit negativer Mesakante, beispielsweise in den folgenden Prozessschritten, aus.

Das erfindungsgemäße Verfahren umfasst zusätzlich zu den Verfahrensschritten A) bis F) die folgenden weiteren Verfahrensschritte: das Aufbringen einer Diffusionsbarriereschicht auf die Spiegelschicht als Verfahrensschritt G), sowie das Aufbringen einer Passivierungsschicht auf die Diffusionsbarriereschicht als Verfahrensschritt H). Die in den Verfahrensschritten A) bis H) gefertigte Schichtenfolge kann in einem weiteren Verfahrensschritt, dem Verfahrensschritt I), auf einen Träger aufgebracht werden.

Ein solcher Träger könnte beispielsweise durch ein Verfahren gefertigt werden, welches die folgenden Verfahrensschritte umfasst: das Bereitstellen einer Trägerscheibe als Verfahrensschritt I1), sowie das Aufbringen einer Sperrschicht auf die Trägerscheibe als Verfahrensschritt I2) und das Aufbringen einer Haftschicht auf die Sperrschicht als Verfahrensschritt I3).

Über die Haftschicht kann die in den Verfahrensschritten A) bis H) gefertigte Schichtenfolge mit dem Träger verbunden werden. Für die Haftschicht kann beispielsweise ein Klebstoff oder ein Lotmaterial verwendet werden. Der Träger dient unter anderem zur Stabilisierung der Schichtenfolge vor allem nach dem Abtrennen des Aufwachssubstrates für die weiteren Verfahrensschritte, sowie beispielsweise für den späteren Einsatz im optoelektronischen Bauelement. Der Träger kann aber auch Aufgaben wie Kontaktierung und Stromleitung im Bauelement wahrnehmen.

Als Aufwachssubstrat im Verfahrensschritt A) wird vorzugsweise ein Saphir oder Si verwendet.

Für die Spiegelschicht im Verfahrensschritt C) kann ein Material verwendet werden, welches als Hauptbestandteil Ag umfasst. Die Spiegelschicht aus Verfahrensschritt C) kann beispielsweise durch ein Verfahren aufgebracht werden ausgewählt aus: Aufdampfen, Sputtern, CVD, Galvanik.

Die Spiegelschicht kann durch einen weiteren Verfahrensschritt, welcher zwischen den Verfahrensschritten C) und D) liegt, strukturiert werden, ohne dass dabei die Halbleiterschicht strukturiert wird. Die Strukturierung kann durch eines der folgenden Verfahren erfolgen: nasschemisches Ätzen, Plasmaätzen, eine Lift-Off-Technik. Die strukturierte Spiegelschicht hat den Vorteil, dass bei Betrieb des Bauelementes an den Stellen, an den die Spiegelschicht entfernt wurde die Stromeinprägung reduziert oder ganz verhindert wird. Somit kann gezielt die Stromeinprägung an den Stellen, wo an der gegenüberliegenden Seite der Halbleiterschicht, der Auskoppelseite, Abschattungen wie Leiterbahnen oder Bondpands liegen, unterbunden werden.

Für die Diffusionsbarriereschicht im Verfahrensschritt G) kann ein Material verwendet werden, welches TiWN und/oder TiN umfasst. Die Diffusionsbarriereschicht kann beispielsweise durch eines der folgenden Verfahren aufgebracht werden: Sputtern, Aufdampfen, CVD-Verfahren.

Die Passivierungsschicht aus Verfahrensschritt E) kann aus drei Unterschichten aufgebaut sein. Die erste Unterschicht kann beispielsweise eine Haftfunktion übernehmen, die zweite eine Sperrfunktion und die dritte, abschließende Schicht die eigentliche Passivierungsfunktion.

Für die Trägerscheibe kann ein Material verwendet werden, welches Ge, Si oder GaAs, AlN, SiN umfasst.
Es sind Ausführungsbeispiele möglich, in denen die Trägerscheibe ein elektrisch leitendes Material umfasst, ebenso sind aber auch Ausführungsformen denkbar, in denen die Trägerscheiben nicht elektrisch leitend ist.

Für die Kontaktschicht des Trägers kann ein Material verwendet werden, welches mindestens eines der Elemente Al, Pt, Au, Zn umfasst. Die Kontaktschicht kann beispielsweise durch eines der folgenden Verfahren aufgebracht werden: Sputtern, Aufdampfen.

Für die Sperrschicht des Trägers kann ein Material verwendet werden, welches TiWN und/oder TiN umfasst. Die Sperrschicht kann beispielsweise durch eines der folgenden Verfahren aufgebracht werden: Sputtern, Aufdampfen, CVD-Verfahren.

Für die Haftschicht des Trägers kann ein Material verwendet werden, welches Sn umfasst. Dem Aufbringen der Schichtenfolge auf den Träger im Verfahrensschritt I) kann ein Erwärmen der Haftschicht vorangehen.

Die strukturierte Halbleiterschicht kann in einem weiteren Verfahrensschritt J1) aufgeraut werden. Dieser Verfahrensschritt erfolgt nach dem Verfahrensschritt F). Anschließend kann die aufgeraute Halbleiterschicht mit einer Deckschicht versehen werden die ein Material umfasst, welches für sichtbare Strahlung, UV-Strahlung, IR-Strahlung oder einer Kombination dieser Strahlungen durchlässig ist (Verfahrensschritt J2)). Für die Beschichtung eignet sich beispielsweise Bisbenzocyclobuten (BCB). Die Deckschicht kann beispielsweise durch Aufschleudern oder Sprühbelackung auf die Halbleiterschicht aufgebracht werden. Der Einsatz von Bisbenzocyclobuten führt hierbei zum guten Ausfüllen von Kanten in Mesagräben. BCB weist des Weiteren eine gute Strahlungsstabilität auf.

Es ist auch eine Verfahrensvariante möglich, in der das Aufrauen des Verfahrensschrittes J1) vor dem Verfahrensschritt F) erfolgen kann.

In einem weiteren Verfahrensschritt J3) kann die Deckschicht strukturiert werden. Dadurch können Teilbereiche der Halbleiterschicht wieder freigelegt werden. Auf diese freigelegten Bereiche kann in einem weiteren Verfahrensschritt J4) ein elektrischer Kontakt aufgebracht werden.

Es ist auch ein Verfahren möglich, bei dem der elektrische Kontakt vor der Deckschicht auf der Halbleiterschicht aufgebracht wird.

Die Erfindung betrifft neben dem Verfahren zur Herstellung des optoelektronischen Bauelements auch das optoelektronische Bauelement selbst.

Eine Ausführungsform des optoelektronischen Bauelements umfasst die folgende Schichtenfolge: eine strukturierte Halbleiterschicht, ein strukturiertes niedrigbrechendes Dielektrikum, welches auf der Halbleiterschicht aufgebracht ist, eine auf der Halbleiterschicht und dem niedrigbrechenden Dielektrikum angeordnete metallische Spiegelschicht, wobei die der Halbleiterschicht zugewandte Seite der metallischen Spiegelschicht Strukturen aufweist, eine auf der metallischen Spiegelschicht angeordnete Diffusionsbarriereschicht, wobei die Halbleiterschicht eine positive Mesaflanke aufweist, eine Passivierungsschicht, welche auf der Diffusionsbarriereschicht angeordnet ist, und eine elektrische Kontaktschicht, welche auf der Passivierungsschicht angeordnet ist. Die Halbleiterschicht weist hierbei an den Flanken eine positive Mesakante auf, d.h. die Mesagräben verengen sich von der freien Oberfläche zur Spiegelschicht hin.

Bei Betrieb des optoelektronischen Bauelements kommt es in der Halbleiterschicht zur Ausbildung einer aktiven Zone, aus der Strahlung emittiert wird. Aufgabe der Spiegelschicht ist es, eine Abgabe der Strahlung in das Bauelement zu unterbinden, so dass die gesamte Strahlung über die Oberseite der Halbleiterschicht nach Außen abgegeben wird. Die Diffusionsbarriereschicht auf der Spiegelschicht soll vor allem im Betrieb des Bauelements ein Wandern der Ionen des Materials, aus dem die Spiegelschicht gefertigt wurde, verhindern.

Eine weitere Ausführungsform des optoelektronische Bauelements umfasst als weitere Schichten eine Trägerscheibe, eine auf der Trägerscheibe angeordnete elektrische Kontaktschicht, eine auf der Kontaktschicht angeordnete Sperrschicht und eine auf der Sperrschicht angeordnete Haftschicht. Hierbei ist die Haftschicht mit der Passivierungsschicht der im vorhergehenden Absatz beschriebenen Schichtenfolge verbunden.

Im Folgenden sollen Varianten der Erfindung anhand von Figuren und Ausführungsbeispielen näher erläutert werden.
- Figur 1a/b: zeigt in einer Gegenüberstellung ein herkömmliches Verfahren (Fig. 1a) und ein Vergleichsbeispiel des erfindungsgemäßen Verfahrens (Fig. 1b).
- Figur 2: zeigt eine schematische Seitenansicht der Schichtenfolge 20.
- Figur 3: zeigt eine schematische Seitenansicht der Schichtenfolge 30.
- Figur 4: zeigt eine schematische Seitenansicht der Schichtenfolge 40.
- Figur 5: zeigt eine schematische Seitenansicht der Schichtenfolge 50.
- Figur 6a: zeigt die schematische Seitenansicht einer erfindungsgemäßen Schichtenfolge mit einem Mesagraben, der eine positive Mesakante aufweist.
- Figur 6b: zeigt die schematische Seitenansicht einer nicht erfindungsgemäßen Schichtenfolge mit einem Mesagraben, der eine negative Mesakante aufweist.
- Figur 7: zeigt die schematische Seitenansicht einer strukturierten Schichtenfolge.
- Figur 8: zeigt die schematische Seitenansicht einer strukturierten Schichtenfolge mit zusätzlich aufgerauter Oberfläche.
- Figur 9: zeigt die schematische Seitenansicht einer strukturierten Schichtenfolge mit beschichteter Oberfläche.
- Figur 10: zeigt die schematische Seitenansicht einer strukturierten Schichtenfolge mit kontaktierter Oberfläche,
- Figur 11: zeigt die schematische Seitenansicht einer Schichtenfolge einer weiteren Ausführungsform,
- Figur 12: zeigt die schematische Seitenansicht einer Schichtenfolge mit strukturierter Halbleiterschicht,
- Figur 13: zeigt die schematische Seitenansicht einer Schichtenfolge mit zweiten Kontakten,
- Figur 14: zeigt die schematische Seitenansicht einer Schichtenfolge mit aufgerauter Halbleiterschicht,
- Figur 15: zeigt die schematische Seitenansicht einer Schichtenfolge mit Mesagraben,
- Figur 16: zeigt die schematische Seitenansicht einer Schichtenfolge mit Deckschicht,
- Figur 17: zeigt die schematische Seitenansicht von vereinzelten Bauelementen,
- Figur 18: zeigt die schematische Seitenansicht einer Schichtenfolge einer weiteren Ausführungsform mit einem niedrigbrechendem Dielektrikum,
- Figur 19: zeigt die schematische Seitenansicht einer Schichtenfolge mit einem Spiegelsystem,
- Figur 20: zeigt die schematische Seitenansicht einer Schichtenfolge mit einer strukturierten metallischen Spiegelschicht,
- Figur 21: zeigt die schematische Seitenansicht einer Schichtenfolge mit einer Diffusionsbarriereschicht,
- Figur 22: zeigt die schematische Seitenansicht einer Schichtenfolge auf einer Trägerscheibe,
- Figur 23: zeigt die schematische Seitenansicht einer Schichtenfolge, welche aus dem zusammenfügen zweier Schichtenfolgen resultiert,
- Figur 24: zeigt die schematische Seitenansicht einer Schichtenfolge mit Rückseitenkontakt,
- Figur 25: zeigt die schematische Seitenansicht einer Schichtenfolge ohne Aufwachssubstrat,
- Figur 26: zeigt die schematische Seitenansicht einer Schichtenfolge mit aufgerauter Halbleiterschicht,
- Figur 27: zeigt die schematische Seitenansicht einer Schichtenfolge mit ersten Kontakten,
- Figur 28: zeigt die schematische Seitenansicht einer erfindungsgemäßen Schichtenfolge mit Mesagraben,
- Figur 29: zeigt die schematische Seitenansicht einer erfindungsgemäßen Schichtenfolge mit Deckschicht,
- Figur 30: zeigt die schematische Seitenansicht erfindungsgemäßer vereinzelter Bauelemente.

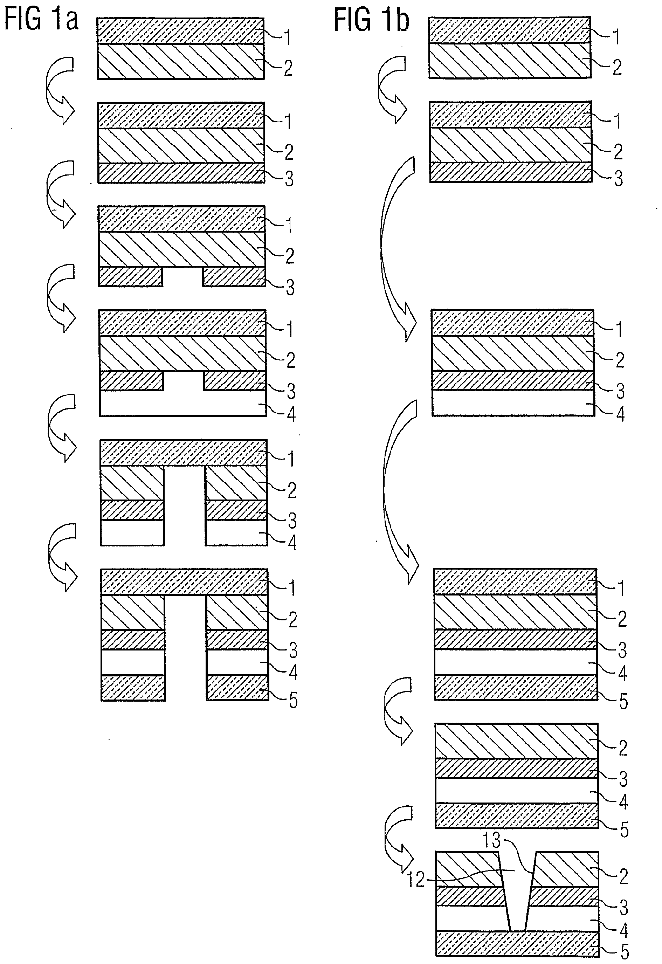

Figur 1a/b zeigt in einer Gegenüberstellung ein herkömmliches Verfahren (Figur 1a) und eine Variante des erfindungsgemäßen Verfahrens (Figur 1b). Sowohl die Figur 1a wie auch die Figur 1b zeigen als erstes eine Schichtenfolge bestehend aus Aufwachssubstrat 1 und Halbleiterschicht 2. In den beiden Verfahren wird als erstes eine metallische Spiegelschicht 3 auf die Halbleiterschicht 2 aufgebracht. In dem herkömmlichen Verfahren wie es in Figur 1a dargestellt ist wird als nächstes unter Zuhilfenahme einer Fototechnik und einer Ätztechnik die metallische Spiegelschicht 3 strukturiert. Dieser Verfahrensschritt entfällt bei dem erfindungsgemäßen Verfahren. In einem nächsten Verfahrensschritt wird auf die metallische Spiegelschicht 3 eine Diffusionsbarriereschicht 4 aufgebracht. Bei den herkömmlichen Verfahren wie es in Figur 1a dargestellt ist hat man das Problem, dass das Material der Diffusionsbarriereschicht nun auch in dem zuvor freigelegten Bereich der metallischen Spiegelschicht vorliegt. In dem herkömmlichen Verfahren aus Figur 1a erfolgt nun eine weitere Fototechnik sowie eine oder mehrere Ätzschritte. Durch die Ätzschritte werden die Diffusionsbarriereschicht 4 strukturiert der zuvor in der metallischen Spiegelschicht 3 freigelegte Bereich wieder freigeätzt sowie die Halbleiterschicht 2 strukturiert. Das Ätzen erfolgt jeweils von der dem Aufwachssubstrat abgewandten Seite her. Diese Verfahrensschritte entfallen in dem in Figur 1b dargestellten Verfahren. In einem weiteren Verfahrensschritt wird auf die Diffusionsbarriereschicht 4 die Passivierungsschicht 5 aufgebracht. In dem in Figur 1a dargestellten Verfahren erfolgt jetzt noch zusätzlich eine weitere Fototechnik sowie Ätztechnik. Die Gegenüberstellung zeigt deutlich, dass bei dem herkömmlichen Verfahren wie es in Figur 1a dargestellt ist, eine deutlich größere Zahl von Verfahrensschritten nötig sind. Vor allem sind hier eine Vielzahl von Foto- und Ätztechniken notwendig, wohingegen bei der Variante des erfindungsgemäßen Verfahrens wie es in Figur 1b dargestellt ist, bis jetzt noch keine einzige Foto- und Ätztechnik Anwendung gefunden hat. Dies stellt einen deutlichen Vorteil gegenüber der herkömmlichen Technik dar. In einem weiteren Verfahrensschritt wird jetzt in dem Verfahren aus Figur 1b das Aufwachssubstrat 1 entfernt, was beispielsweise mittel Laser-Lift-Off erfolgen kann, und somit eine Oberfläche der Halbleiterschicht 2 freigelegt. Die Halbleiterschicht 2 kann jetzt von der freigelegten Seite mittels eines einzigen Fotolithographieschrittes und eines einzigen Ätzschrittes strukturiert werden. Im Ätzschritt wird der Mesagraben 12 mit den Mesaflanken 13 geätzt.

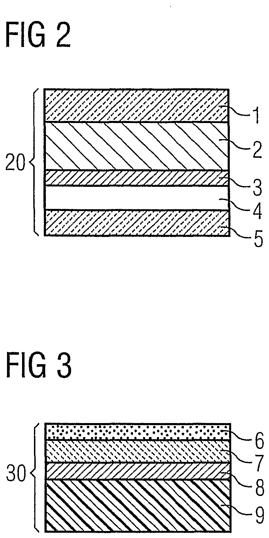

Figur 2 zeigt eine schematische Seitenansicht einer durch ein Vergleichsbeispiel des erfindungsgemäßen Verfahrens erzeugte Schichtenfolge 20. Diese umfasst fünf Schichten mit der Schichtenfolge Aufwachssubstrat 1, Halbleiterschicht 2, Spiegelschicht 3, Diffusionsbarriereschicht 4, Passivierungsschicht 5.

Figur 3 zeigt eine schematische Seitenansicht einer durch ein Vergleichsbeispiel des erfindungsgemäßen Verfahrens erzeugte Schichtenfolge 30, welche beispielsweise als Träger verwendet werden kann und mit der in Figur 2 dargestellten Schichtenfolge 20 verbunden werden kann. Dieser umfasst eine Trägerscheibe 9, darauf angeordnet eine Kontaktschicht 8, darauf angeordnet eine Sperrschicht 7, darauf angeordnet eine Haftschicht 6. Die Haftschicht 6 dient hierbei zur späteren Verbindung der Schichtenfolge 30 mit beispielsweise der Schichtenfolge 20 wie sie in Figur 2 dargestellt ist.

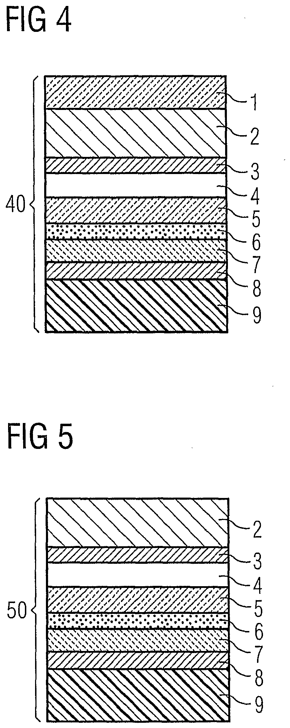

Figur 4 zeigt eine schematische Seitenansicht einer durch ein Vergleichsbeispiel des erfindungsgemäßen Verfahrens erzeugte Schichtenfolge 40. Die Schichtenfolge 40 resultiert aus der Zusammenführung der Schichtenfolge 20 und 30 wie sie in Figur 2 beziehungsweise Figur 3 dargestellt sind. Die Schichtenfolge 20 und 30 werden über das Haftmaterial der Haftschicht 6 verbunden. Durch das Zusammenfügen der Schichtenfolge 20 und 30 werden die Schichten 2 bis 5 der Schichtenfolge 20 nun zusätzlich durch den Schichtenfolge 30 stabilisiert, was für ausreichende Stabilität auch nach dem Abtrennen des Aufwachssubstrats 1 sorgt.

Figur 5 zeigt eine schematische Seitenansicht einer durch ein Vergleichsbeispiel des erfindungsgemäßen Verfahrens erzeugte Schichtenfolge 50. Diese resultiert beispielsweise aus einer Schichtenfolge 40 wie er in Figur 4 dargestellt ist durch das Abtrennen des Aufwachssubstrates 1. Das Abtrennen kann wie im Verfahrenschritt E) beschrieben erfolgen. Dieses kann beispielsweise durch ein Laser-Lift-Off erfolgen. Die noch aus dem Schichtenfolge 20 verbleibenden Schichten 2, 3, 4, und 5 werden nun durch den Schichtenfolge 30 stabilisiert. Eine Oberfläche der Halbleiterschicht 2, die zuvor mit dem Aufwachssubstrat 1 verbunden war, ist jetzt wieder freigelegt und kann von der freigelegten Seite strukturiert werden.

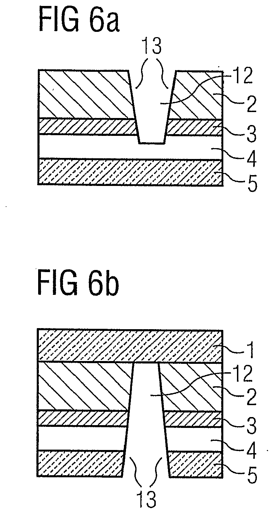

Figur 6a zeigt die schematische Seitenansicht einer Schichtenfolge, wie sie beispielsweise aus einer Schichtenfolge hervorgehen könnte, wie sie in Fig. 2 dargestellt ist. Hierzu müssten noch ich weiteren Verfahrensschritten das Aufwachssubstrat 1 abgelöst worden sein, wie in Verfahrensschritt E) beschrieben, und die Halbleiterschicht 2 und die metallische Spiegelschicht 3 mittels eines Ätzverfahrens strukturiert worden sein, wie in Verfahrensschritt F) beschrieben. Die Fig. 6a zeigt einen Mesagraben 12, welcher eine positive Mesakante 13 aufweist. Das heißt, der Mesagraben 12 verengt sich in die Halbleiterschicht 2 hinein, also von der freien Oberfläche, welche zuvor mit den Aufwachssubstrat verbunden war in Richtung der unter der Halbleiterschicht 2 folgenden Schichten, wie beispielsweise der metallische Spiegelschicht 3 .

Figur 6b zeigt die schematische Seitenansicht einer durch ein nicht erfindungsgemäßen Verfahrens erzeugten Schichtenfolge. Die Schichtenfolge weist einen Mesagraben 12 auf, umfasst aber noch das Aufwachssubstrat 1. Die Halbleiterschicht 2 wurde hier von der dem Aufwachssubstrat abgewandten Seite geätzt. Der Mesagraben 12 weist eine negative Mesakante 13 auf. Das heißt, nach dem Abtrennen des Aufwachssubstrates 1 erweitert sich der Mesagraben 12 von der dann freigelegten Oberfläche in die Halbleiterschicht hinein. Die weiteren Schichten metallische Spiegelschicht 3, Diffusionsbarriereschicht 4 sowie Passivierungsschicht 5 wurde ebenfalls von der dem Aufwachssubstrat abgewandten Seite her strukturiert.

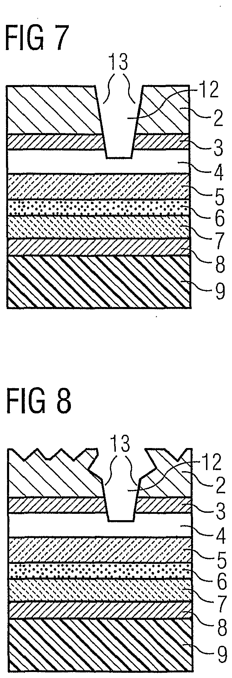

Figur 7 zeigt eine schematische Seitenansicht einer Ausführungsform einer strukturierten Schichtenfolge. Ein solche geht beispielsweise durch Strukturierung einer Schichtenfolge 50 wie sie in Figur 5 dargestellt ist hervor. In Figur 7 sind die Halbleiterschicht 2 und die Spiegelschicht 3 durch den Mesagraben 12 der durch die Strukturierung erzeugt wurde vollständig unterbrochen. Die Halbleiterschicht 2 weist hierbei einen Mesagraben 12 mit positiver Mesaflanke 13 auf. Der Querschnitt des Grabens verengt sich von der Oberfläche die zuvor mit dem Aufwachssubstrat 1 verbunden war in Richtung Spiegelschicht 3. Die in Figur 7 dargestellte Schichtenfolge kann mittels eines einzigen Fotolithografieschrittes beziehungsweise Ätzschrittes erhalten werden.

Figur 8 zeigt eine schematische Seitenansicht einer Ausführungsform einer strukturierten Schichtenfolge, bei der zusätzlich auch noch die Oberfläche aufgeraut ist. Eine solche Schichtenfolge geht beispielsweise aus der in Figur 7 dargestellt Schichtenfolge hervor. Die Strukturierung der Oberfläche kann wie in Verfahrensschritt J1) beschrieben erfolgen.

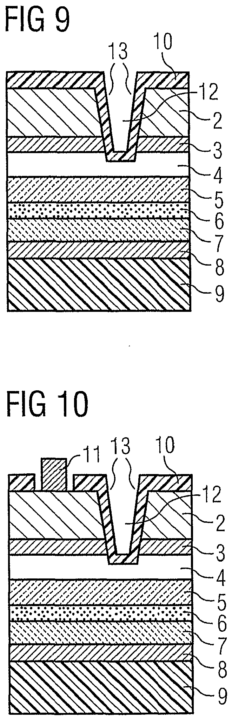

Figur 9 zeigt eine schematische Seitenansicht einer Ausführungsform einer strukturierten Schichtenfolge, bei der zusätzlich noch die Oberfläche mit einer Deckschicht 10 beschichtet ist. Eine solche Schichtenfolge geht beispielsweise aus der in Figur 8 dargestellten Schichtenfolge hervor. Die Beschichtung der Oberfläche kann wie in Verfahrensschritt J2) beschrieben, erfolgen. Für die Deckschicht 10 eignet sich beispielsweise Bisbenzocyclobuten (BCB). Durch die Deckschicht 10 wird die Oberfläche des Bauelements passiviert und geschützt.

Figur 10 zeigt eine schematische Seitenansicht einer Ausführungsform einer strukturierten Schichtenfolge, bei der zusätzlich noch die Oberfläche mit einem elektrischen Kontakt 11 kontaktiert ist. Eine solche Schichtenfolge geht beispielsweise aus der in Figur 9 dargestellten Schichtenfolge hervor. Die Kontaktierung der Oberfläche kann wie in Verfahrensschritt J4) beschrieben erfolgen, nachdem die Deckschicht 10 wie in Verfahrensschritt J3) beschrieben zuvor strukturiert wurde.

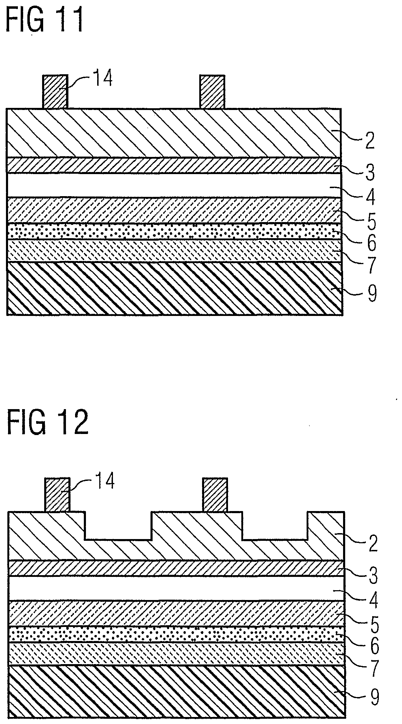

Figur 11 zeigt eine schematische Seitenansicht einer Ausführungsform einer Schichtanordnung umfassend eine Schichtenfolge: eine Trägerscheibe 9, eine Sperrschicht 7, eine Haftschicht 6, eine Passivierungsschicht 5, eine Diffusionsbarriereschicht 4, eine metallische Spiegelschicht 3 und eine Halbleiterschicht 2. Auf der Halbleiterschicht 2 sind des Weiteren zwei erste Kontakte 14 angeordnet. Die beiden ersten Kontakte 14 dienen zur späteren elektrischen Kontaktierung des Bauelements mit einer ersten Ladung, was beispielsweise über einen Draht erfolgen kann.

Die Figur 12 zeigt eine schematische Seitenansicht einer Ausführungsform einer Schichtenanordnung, wie sie aus der Ausführungsform hervorgehen könnte, wie sie in Figur 11 dargestellt ist. Hierbei wurde in einem weiteren Verfahrensschritt die Halbleiterschicht 2 strukturiert. Bei den beiden ersten Kontakten 14 kann es sich beispielsweise um n-Kontakte handeln. Durch die Strukturierung der Halbleiterschicht 2 ist eine leitende Schicht der Halbleiterschicht 2 freigelegt worden, bei der es sich für den Fall, dass es sich bei den ersten Kontakten 14 um n-Kontakte handelt, eine p-Schicht handelt. Für den Fall, dass es sich bei den ersten Kontakten um p-Kontakte handelt, so wäre die freigelegte Schicht eine n-Schicht.

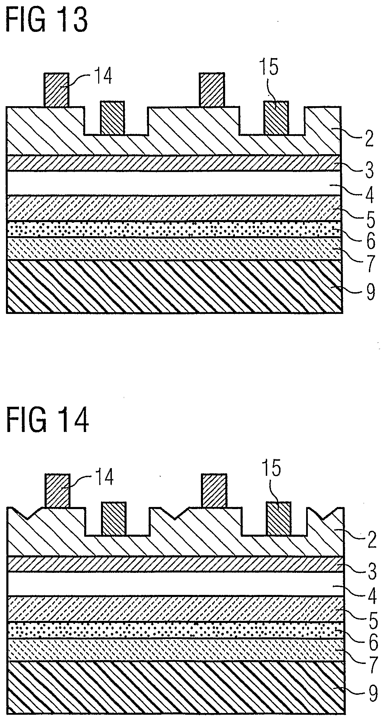

Die Figur 13 zeigt eine schematische Seitenansicht einer Ausführungsform wie sie beispielsweise aus der Ausführungsform hervorgehen könnte wie sie in Figur 12 dargestellt ist. Die in Figur 13 dargestellte Ausführungsform umfasst zusätzlich zwei zweite Kontakte 15, welche auf der Schicht angeordnet sind, welche in der Ausführungsform von Figur 12 freigelegt wurde. Diese zwei zweiten Kontakte 15 können beispielsweise p-Kontakte sein. Sie dienen ebenso wie die ersten Kontakte 14 zur späteren elektrischen Kontaktierung des Bauelements, jedoch mit der entsprechend entgegen gesetzten Ladung.

Die Figur 14 zeigt eine schematische Seitenansicht einer Ausführungsform, bei der die Oberfläche der Halbleiterschicht 2 aufgeraut ist. Diese könnte aus der Ausführungsform hervorgehen, wie sie in Figur 13 dargestellt ist. Hierzu wurde in einem weiteren Verfahrensschritt die Oberfläche der Halbleiterschicht 2 aufgeraut. Das Aufrauen erfolgt gemäß Verfahrensschritt J1).

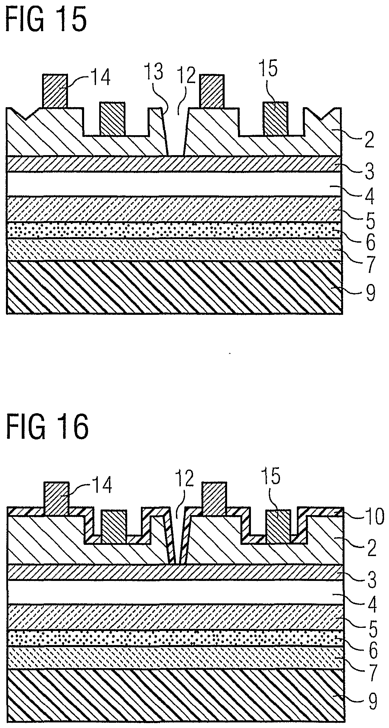

Die Figur 15 zeigt eine schematische Seitenansicht einer Ausführungsform mit Mesagraben 12 wie sie aus der Ausführungsform hervorgehen könnte wie sie in Figur 14 dargestellt ist. Die Figur 15 weist zusätzlich einen Mesagraben 12 auf, welcher mittels eines Ätzschrittes in die Halbleiterschicht 2 geätzt worden ist. Der Ätzschritt erfolgt von der freien Oberseite, so dass der Mesagraben 12 eine positive Mesaflanke 13 aufweist.

Figur 16 zeigt eine schematische Seitenansicht einer Ausführungsform mit Deckschicht 10. Diese könnte aus der Ausführungsform hervorgehen wie sie in Figur 15 dargestellt ist. Hierzu wurde die Oberfläche der Halbleiterschicht 2 mit einer Deckschicht 10 versehen. Die Deckschicht 10 dient zur Passivierung und zum Schutz der Halbleiterschicht 2. Die Deckschicht 10 wurde so aufgetragen, dass die ersten und zweiten Kontakte 14/15 noch frei sind und nicht beschichtete Flächen aufweisen, so dass eine elektrische Kontaktierung noch möglich ist.

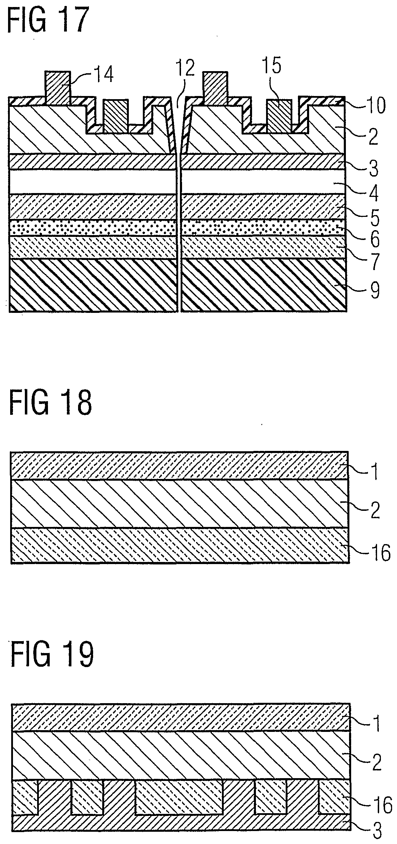

In Figur 17 ist eine schematische Seitenansicht einer Ausführungsform von vereinzelten Bauelementen dargestellt. Diese könnte beispielsweise aus der Ausführungsform hervorgehen wie sie in Figur 16 dargestellt ist. In einem weiteren Verfahrensschritt wurden die beiden Bauelemente vereinzelt. Hierzu wurde am Boden des Mesagraben 12 beispielsweise ein weiterer Ätzprozess durchgeführt, durch welchen alle weiteren Schichten durchtrennt wurden. Das Trennen kann beispielsweise mit Hilfe von Laser Dicing erfolgen.

Figur 18 zeigt eine schematische Seitenansicht einer weiteren Ausführungsform. Diese Ausführungsform umfasst die Schichtenfolge: ein niedrigbrechendes Dielektrikum 16 darauf angeordnet eine Halbleiterschicht 2, darauf angeordnet ein Aufwachssubstrat 1. Bei dem Aufwachssubstrat 1 kann es sich beispielsweise um Saphir oder Silizium handeln. Für die Halbleiterschicht 2 kann beispielsweise GaInN verwendet werden. Die Halbleiterschicht 2 kann durch Aufwachsen gemäß Verfahrensschritt B) auf dem Aufwachssubstrat 1 entstanden sein. Für das niedrigbrechendes Dielektrikum 16, welches ein Teil des Spiegelsystems darstellt, kann beispielsweise SiO₂ verwendet werden.

Figur 19 zeigt eine schematische Seitenansicht einer Ausführungsform wie sie aus dem erfindungsgemäßen Verfahren nach den Verfahrensschritten A) bis C) hervorgeht. Die in Figur 19 dargestellte Ausführungsform umfasst zusätzlich eine metallische Spiegelschicht 3, welche auf dem niedrigbrechendem Dielektrikum 16 angeordnet ist. Vor dem Aufbringen der metallischen Spiegelschicht 3, welches gemäß Verfahrensschritt C) erfolgt, wurden Teilbereiche des niedrigbrechendem Dielektrikums 16 entfernt, so dass die metallische Spiegelschicht 3 in Teilbereichen das niedrigbrechende Dielektrikum 16 durchdringt. Diese Teilbereiche reichen bis zur Halbleiterschicht 2. Für die metallische Spiegelschicht 3 kann beispielsweise Ag verwendet werden. Die Kombination aus dem niedrigbrechendem Dielektrikum 16 und der metallischen Spiegelschicht 3 bilden zusammen ein Spiegelsystem aus.

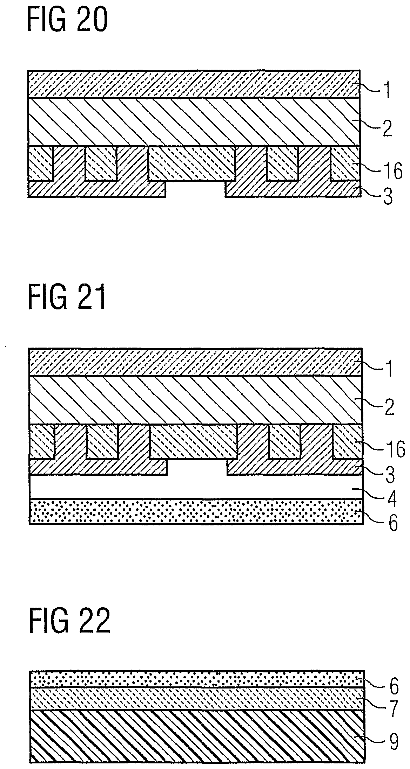

Figur 20 zeigt eine schematische Seitenansicht einer Ausführungsform mit strukturierter metallischen Spiegelschicht 3. Diese könnte aus der Ausführungsform hervorgehen wie sie in Figur 19 dargestellt ist. Bei der in Figur 20 dargestellten Ausführungsform wurde die metallische Spiegelschicht 3 strukturiert. Durch das Strukturieren der metallischen Spiegelschicht 3 wurde ein Teilbereich des niedrigbrechenden Dielektrikums 16 freigelegt.

Figur 21 zeigt eine schematische Seitenansicht einer Ausführungsform wie sie beispielsweise aus der Ausführungsform hervorgehen könnte, wie sie in Figur 20 dargestellt ist. Die in Figur 21 dargestellte Ausführungsform umfasst des Weiteren eine Diffusionsbarriereschicht 4, welche auf der metallischen Spiegelschicht 3 angeordnet ist. In dem Teilbereich, wo die Spiegelschicht entfernt wurde, reicht die Diffusionsbarriereschicht 4 bis zum niedrigbrechenden Dielektrikum 16. Für die Diffusionsbarriereschicht 4 kann beispielsweise Ti verwendet werden. Auf der Diffusionsbarriereschicht 4 ist des Weiteren eine Haftschicht 6 angeordnet. Für die Haftschicht 6 kann beispielsweise Au verwendet werden. Die Haftschicht 6 dient zur späteren Verbindung der Schichtenfolge mit weiteren Schichten oder Schichtenfolgen.

Figur 22 zeigt eine schematische Seitenansicht einer weiteren Schichtenfolge. Diese Schichtenfolge umfasst eine Trägerscheibe 9, darauf angeordnet eine Sperrschicht 7, darauf angeordnet eine Haftschicht 6. Die Trägerscheibe 9 kann aus einem elektrisch leitenden Material wie beispielsweise Silizium gefertigt sein. Die Sperrschicht 7 kann unter anderem zur Haftvermittlung zwischen der Trägerscheibe 9 und der Haftschicht 6 dienen. Für die Sperrschicht 7 kann beispielsweise Ti verwendet werden. Für die Haftschicht 6 kann beispielsweise eine Schichtenfolge aus Au und Sn verwendet werden.

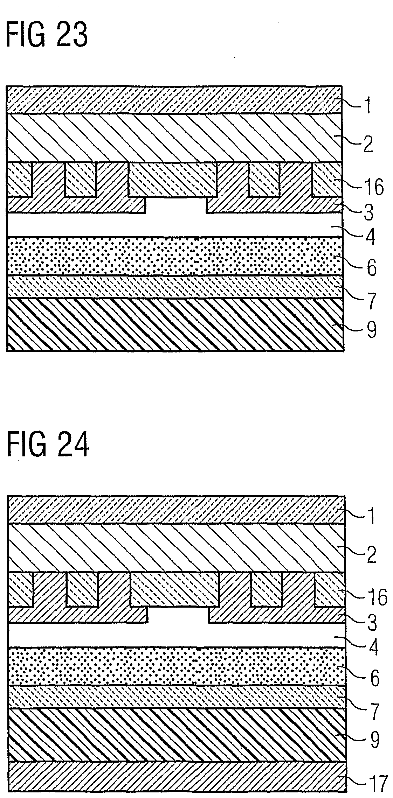

Figur 23 zeigt eine schematische Seitenansicht einer Ausführungsform wie sie beispielsweise aus dem Zusammenfügen der Schichtenfolgen hervorgeht, wie sie in Figur 21 und 22 dargestellt sind. Hierzu wurden die beiden Schichtenfolgen jeweilige über ihre Haftschicht 6 miteinander verbunden.

Figur 24 zeigt eine schematische Seitenansicht einer Ausführungsform mit einem Rückseitenkontakt 17. Diese könnte beispielsweise aus der Ausführungsform hervorgehen wie sie in Figur 23 dargestellt ist. Die in Figur 24 dargestellte Ausführungsform umfasst zusätzlich einen Rückseitenkontakt 17, welcher auf der Trägerscheibe 9 angeordnet ist. Der Rückseitenkontakt 17 kann zur elektrischen Kontaktierung des Bauelements verwendet werden.

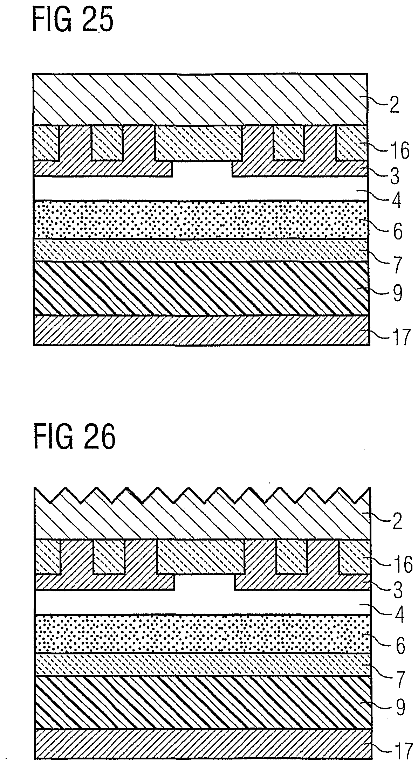

Figur 25 zeigt eine schematische Seitenansicht einer Ausführungsform wie sie beispielsweise aus der Ausführungsform hervorgehen könnte, wie sie in Figur 24 dargestellt ist. Hierzu wurde gemäß Verfahrensschritt C) das Aufwachssubstrat 1 von der Halbleiterschicht 2 entfernt. Dies kann beispielsweise mittels Laser-Lift-Off erfolgen.

Figur 26 zeigt eine schematische Seitenansicht einer Ausführungsform, bei der die Oberfläche der Halbleiterschicht 2 aufgeraut ist. Diese könnte beispielsweise aus der Ausführungsform hervorgehen wie sie in Figur 25 dargestellt ist. Hierzu wurde in einem weiteren Verfahrensschritt die Oberfläche der Halbleiterschicht 2 aufgeraut.

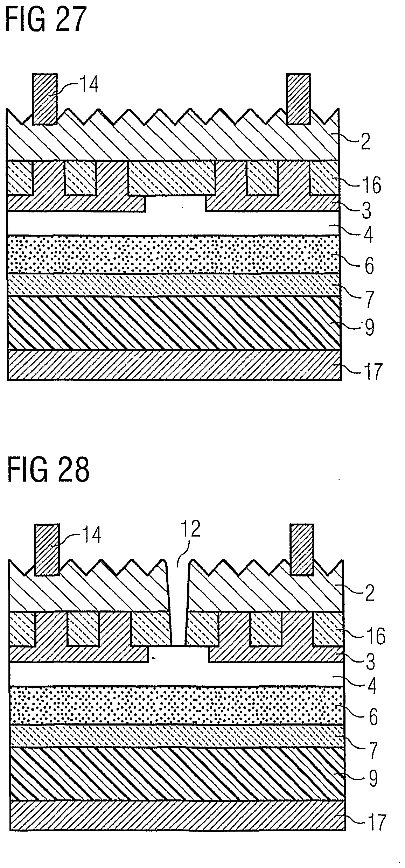

Figur 27 zeigt eine schematische Seitenansicht einer Ausführungsform wie sie beispielsweise aus der Ausführungsform hervorgehen könnte, wie sie in Figur 26 dargestellt ist. Die in Figur 27 dargestellte Ausführungsform umfasst zusätzlich zwei erste Kontakte 14. Über diese ersten Kontakte 14 kann das Bauelement elektrisch kontaktiert werden. Das Bauelement verfügt somit sowohl auf der Vorderwie auch auf der Rückseite jeweils über Elemente zur elektrischen Kontaktierung.

Die Figur 28 zeigt eine schematische Seitenansicht einer erfindungsgemäßen Ausführungsform mit einem Mesagraben 17. Diese könnte beispielsweise aus der Ausführungsform hervorgehen wie sie in Figur 27 dargestellt ist. Hierzu wurde in einem Verfahrensschritt entsprechend Verfahrensschritt F) ein Mesagraben 12 geätzt. Der Mesagraben 12 durchläuft die Halbleiterschicht 2 und das niedrigbrechende Dielektrikum 16. Der Mesagraben 12 wurde von der Seite geätzt, die zuvor mit dem Aufwachssubstrat 1 verbunden war. Der Mesagraben 12 weist dadurch eine positive Mesaflanke auf. Der Mesagraben 12 wurde so in das Bauelement geätzt, dass er auf den Teilbereich trifft, in dem die metallische Spiegelschicht 3 vorher entfernt wurde, so dass der Mesagraben 12 auf der Diffusionsbarriere 4 endet.

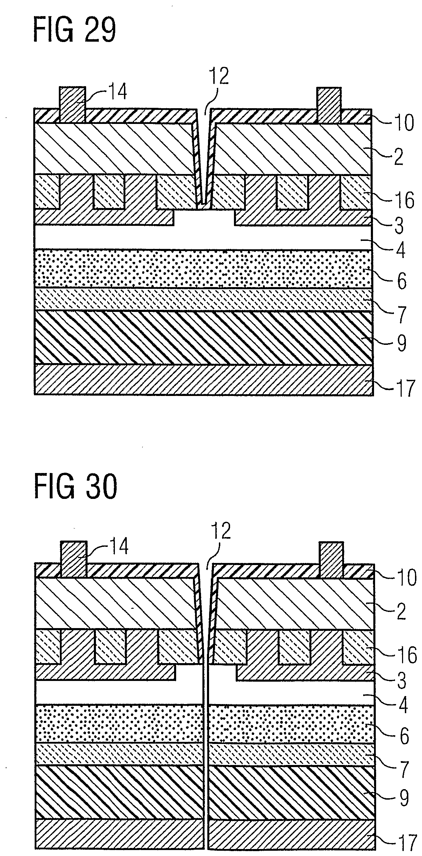

Figur 29 zeigt eine schematische Seitenansicht einer Ausführungsform wie sie beispielsweise aus der Ausführungsform hervorgehen könnte, wie sie in Figur 28 dargestellt ist. Hierzu wurde gemäß Verfahrensschritt J2) die Oberfläche des Bauelements mit einer Deckschicht 10 versehen.

Die Deckschicht 10 kleidet auch die Seitenwände des Mesagrabens 12, also die Mesaflanken, aus. Die Deckschicht 10 dient zur Passivierung und Vergütung des Bauelements. Die Deckschicht 10 wird so auf die Oberfläche des Bauelements aufgebracht, dass das Bauelement immer noch über die ersten Kontakte 14 elektrisch kontaktiert werden kann. Diese können aber auch erst vollkommen mit der Deckschicht 10 bedeckt sein und Teilbereiche wieder in einem weiteren Verfahrensschritt freigelegt werden.

Figur 30 zeigt eine schematische Seitenansicht von vereinzelten Bauelementen. Diese könnten beispielsweise aus der Ausführungsform hervorgehen wie sie in Figur 29 dargestellt ist. Hierzu wurden in einem weiteren Verfahrensschritt die beiden zuvor zusammenhängenden Elemente vereinzelt. Hierzu wurde am Boden des Mesagrabens 12 beispielsweise ein weiterer Ätzschritt durchgeführt, welche die restlichen Schichten durchtrennt. Dieses Durchtrennen kann beispielsweise mittels Laser Dicing durchgeführt werden.

Die Erfindung ist nicht durch die Beschreibung anhand der Ausführungsbeispiele beschränkt.

## Patentansprüche

1. Verfahren zur Herstellung eines optoelektronischen Bauelements, umfassend die Verfahrensschritte:
A) Bereitstellen eines Aufwachssubstrates (1),
B) Epitaktisches Aufwachsen zumindest einer Halbleiterschicht (2) zur Erzeugung einer im Betrieb aktiven Zone,
B1) Aufbringen eines niedrigbrechenden Dielektrikums (16) auf die Halbleiterschicht (2) und Entfernen von Teilbereichen des niedrigbrechenden Dielektrikums (16),
C) Aufbringen einer metallischen Spiegelschicht (3) auf die Halbleiterschicht (2) und das niedrigbrechende Dielektrikum (16), sodass die metallische Spiegelschicht (3) in den Teilbereichen das niedrigbrechende Dielektrikum (16) durchdringt,
G) Aufbringen einer Diffusionsbarriereschicht (4) auf der metallischen Spiegelschicht (3),
H) Aufbringen einer Passivierungsschicht (5) auf der Diffusionsbarriereschicht (4),
D) Aufbringen zumindest einer Kontaktschicht (8) zur elektronischen Kontaktierung des Bauelements,
E) Abtrennen des Aufwachssubstrates (1) von der Halbleiterschicht (2), wobei eine Oberfläche der Halbleiterschicht (2) freigelegt wird,
F) Strukturieren der Halbleiterschicht (2) mittels eines Ätzverfahrens von Seiten der Oberfläche, die in Verfahrensschritt E) freigelegt wurde, so dass die Halbleiterschicht (2) Mesagräben (12) mit einer positiven Mesaflanke aufweist, wobei sich die Mesagräben (12) von der Seite der Oberfläche zur Spiegelschicht (3) hin verengen.

2. Verfahren nach Anspruch 1,
wobei die metallische Spiegelschicht (3) im Verfahrensschritt C) auf die unstrukturierte Halbleiterschicht (2) aufgebracht wird.

3. Verfahren nach einem der vorhergehenden Ansprüche,
wobei durch das Strukturieren im Verfahrensschritt F) Gräben erzeugt werden, durch die die Halbleiterschicht (2) in mehrere Teilbereiche unterteilt wird.

4. Verfahren nach einem der vorhergehenden Ansprüche, welches zusätzlich den folgenden Verfahrensschritt zwischen dem Verfahrensschritt C) und D) umfasst:
I) Aufbringen der in den Verfahrensschritten A), B), B1), C), D), E), F), G) bis H) gefertigten Schichtenfolge auf einen Träger.

5. Verfahren nach Anspruch 4, wobei im Verfahrenschritt I) ein Träger verwendet wird, der durch ein Verfahren gefertigt wird, welches folgende Verfahrensschritte umfasst:
I1) Bereitstellen einer Trägerscheibe (9),
I2) Aufbringen einer Sperrschicht (7) auf die Trägerscheibe (9),
I3) Aufbringen einer Haftschicht (6) auf die Sperrschicht (7).

6. Verfahren nach einem der vorhergehenden Ansprüche,
wobei die Spiegelschicht (3) aus Verfahrensschritt C) durch einen weiteren Verfahrensschritt C1), der zwischen den Verfahrensschritten C) und D) liegt, strukturiert wird, sodass Teilbereiche der Spiegelschicht (3) entfernt werden.

7. Verfahren nach einem der vorhergehenden Ansprüche, welches nach dem Verfahrensschritt F) das Aufrauen der strukturierten Halbleiterschicht (2) als weiteren Verfahrenschritt J1) umfasst.

8. Verfahren nach Anspruch 7, welches nach dem Verfahrensschritt J1) das Beschichten der aufgerauten Halbleiterschicht (2) mit einer für sichtbare Strahlung, UV-Strahlung, IR-Strahlung oder einer Kombination dieser Strahlungen durchlässigen Deckschicht (10), die Bisbenzocyclobuten enthält, als weiteren Verfahrenschritt J2) umfasst.

9. Verfahren nach Anspruch 8, welches nach dem Verfahrensschritt J2) die Strukturierung der Deckschicht (10) als weiteren Verfahrenschritt J3) umfasst.

10. Verfahren nach Anspruch 9, welches nach dem Verfahrensschritt J3) das Aufbringen eines elektrischen Kontaktes (11) auf einen Teilbereich der durch die Strukturierung der Deckschicht (10) wieder freigelegten Halbleiterschicht (2) als weiteren Verfahrenschritt J4) umfasst.

11. Verfahren nach einem der vorhergehenden Ansprüche, wobei Strukturen der im Verfahrensschritt C) aufgebrachten Spiegelschicht (3) bis zur Halbleiterschicht (2) reichen.

12. Optoelektronisches Bauelement, umfassend:
- eine strukturierte Halbleiterschicht (2),
- ein strukturiertes niedrigbrechendes Dielektrikum (16), welches auf der Halbleiterschicht (2) aufgebracht ist,
- eine auf der Halbleiterschicht (2) und dem niedrigbrechenden Dielektrikum (16) angeordnete metallische Spiegelschicht (3), wobei die der Halbleiterschicht (2) zugewandte Seite der metallischen Spiegelschicht (3) Strukturen aufweist,
- eine auf der metallischen Spiegelschicht (3) angeordnete Diffusionsbarriereschicht (4),
wobei die Halbleiterschicht (2) Mesagräben (17) mit einer positiven Mesaflanke (13) aufweist, wobei sich die Mesagräben (12) von einer freien Oberfläche der Halbleiterschicht (2) zur Spiegelschicht (3) hin verengen,
- eine Passivierungsschicht (5), welche auf der Diffusionsbarriereschicht (4) angeordnet ist, und
- eine elektrische Kontaktschicht (8), welche auf der Passivierungsschicht (5) angeordnet ist.

13. Optoelektronisches Bauelement nach Anspruch 12, umfassend:
- eine Trägerscheibe (9), wobei die Kontaktschicht (8) auf der Trägerscheibe (9) angeordnet ist,
- eine Sperrschicht (7) angeordnet auf der Kontaktschicht (8),
- eine Haftschicht (6) angeordnet auf der Sperrschicht (7), wobei die Haftschicht (6) mit der Passivierungsschicht (5) verbunden ist.

## Claims

1. Method of producing an optoelectronic component comprising the steps:
A) providing a growth substrate (1),
B) growing at least one semiconductor layer (2) epitaxially to produce an operationally active zone,
Bl) applying a low refractive index dielectric (16) on the semiconductor layer (2) and removing the low refractive index dielectric (16) in sub-regions,
C) applying a metallic mirror layer (3) to the semiconductor layer (2) and to the low refractive index dielectric (16), so that the metallic mirror layer (3) penetrates the low refractive index dielectric (16) in the sub-regions,
G) applying a diffusion barrier layer (4) to the metallic mirror layer (3),
H) applying a passivation layer (5) on the diffusion barrier layer (4),
D) applying at least one contact layer (8) for electronic contacting of the component,
E) detaching the growth substrate (1) from the semiconductor layer (2), wherein a surface of the semiconductor layer (2) is exposed,
F) structuring the semiconductor layer (2) via an etching method from the side of the surface which was exposed in method step E), so that the semiconductor layer (2) comprises mesa trenches (12) with a positive mesa flank, wherein the mesa trenches (12) taper from the side of the surface towards the mirror layer (3).

2. Method according to claim 1,
wherein the metallic mirror layer (3) is applied to the unstructured semiconductor layer (2) in step C).

3. Method according to one of the preceding claims,
wherein the structuring in step F) produces trenches dividing the semiconductor layer (2) into several sub-regions.

4. Method according to one of the preceding claims,
further comprising the following steps between steps C) and D) :
I) applying the layer sequence produced in steps A), B), B1), C), D), E), F), G) to H) on a carrier.

5. Method according to claim 4,
wherein in step I) a carrier is used that is produced by a process comprising the following steps:
I1) providing a carrier wafer (9),
I2) applying a blocking layer (7) to the carrier wafer (9),
I3) applying a bonding layer (6) to the blocking layer (7).

6. Method according to one of the preceding claims,
wherein the mirror layer (3) of step C) is structured in a further step C1) which is carried out between steps C) and D), such that the mirror layer (3) is removed in sub-regions.

7. Method according to one of the preceding claims, comprising roughening of the structured semiconductor layer (2) as a further step J1) after step F).

8. Method according to claim 7,
comprising coating the roughened semiconductor layer (2) with a cover layer (10) which is transmissive for visible radiation, UV-radiation, IR-radiation or any combination of these radiation and comprises bisbenzocyclobutene as a further step J2) after step J1).

9. Method according to claim 8,
comprising structuring the cover layer (10) as a further step J3) after step J2).

10. Method according to claim 9,
comprising applying a electric contact (11) on a sub-region of the semiconductor layer (2) exposed by the structuring of the cover layer (10) as a further step J4) after step J3).

11. Method according to one of the preceding claims,
wherein structures of the mirror layer (3) applied in step C) expand to the semiconductor layer (2).

12. Optoelectronic component, comprising:
- a structured semiconductor layer (2),
- a structured low refractive index dielectric (16) arranged on the semiconductor layer (2),
- a metallic mirror layer (3) arranged on the semiconductor layer (2) and the low refractive index dielectric (16), wherein a side of the metallic mirror layer (3) facing the semiconductor layer (2) comprises structures,
- a diffusion barrier layer (4) arranged on the metallic mirror layer (3),
wherein the semiconductor layer (2) comprises mesa trenches (12) with a positive mesa flank (13), wherein the mesa trenches (12) taper from an exposed surface of the semiconductor layer (2) towards the mirror layer (3),
- a passivation layer (5) arranged on the diffusion barrier layer (4), and
- an electric contact layer (8) arranged on the passivation layer (5).

13. Optoelectronic component according to claim 12, comprising:
- a carrier wafer (9), wherein the contact layer (8) is arranged on the carrier wafer (9),
- a blocking layer (7) arranged on the contact layer (8),
- a bonding layer (6) arranged on the blocking layer (7),
wherein the bonding layer (6) is connected to the passivation layer (5).

## Revendications

1. Procédé de fabrication d'un composant optoélectronique, comprenant les étapes suivantes :
A) Mise à disposition d'un substrat de croissance (1),
B) Croissance épitaxiale d'au moins une couche semi-conductrice (2) pour produire une zone active en fonctionnement,
B1) Application d'un diélectrique à faible réfraction (16) sur la couche semi-conductrice (2) et retrait de zones partielles du diélectrique à faible réfraction (16),
C) Application d'une couche miroir métallique (3) sur la couche semi-conductrice (2) et le diélectrique à faible réfraction (16) de manière que la couche miroir métallique (3) pénètre le diélectrique à faible réfraction (16) dans les zones partielles,
G) Application d'une couche barrière de diffusion (4) sur la couche miroir métallique (3),
H) Application d'une couche de passivation (5) sur la couche barrière de diffusion (4),
D) Application d'au moins une couche de contact (8) pour le contact électronique du composant,
E) Séparation du substrat de croissance (1) de la couche semi-conductrice (2), une surface de la couche semi-conductrice (2) étant ainsi exposée,
F) Structuration de la couche semi-conductrice (2) par un procédé de gravure depuis la surface exposée à l'étape E), de manière que la couche semi-conductrice (2) présente des tranchées mesa (12) dotées d'un flanc mesa positif, les tranchées mesa (12) se rétrécissant depuis la surface vers la couche miroir (3).

2. Procédé selon la revendication 1,
la couche miroir métallique (3) étant appliquée sur la couche semi-conductrice non structurée (2) à l'étape C).

3. Procédé selon l'une des revendications précédentes,
la structuration à l'étape F) produisant des tranchées divisant la couche semi-conductrice (2) en plusieurs zones partielles.

4. Procédé selon l'une des revendications précédentes, comprenant en outre l'étape suivante entre les étapes C) et D) :
I) Application de la succession de couches produite aux étapes A), B), B1), C), D), E), F), G) à H) sur un support.

5. Procédé selon la revendication 4,
un support produit par un procédé comprenant les étapes suivantes étant utilisé à l'étape I) :
I1) Mise à disposition d'un disque support (9),
I2) Application d'une couche barrière (7) sur le disque support (9),
I3) Application d'une couche adhésive (6) sur la couche barrière (7).

6. Procédé selon l'une des revendications précédentes,
la couche miroir (3) de l'étape C) étant structurée lors d'une autre étape C1) située entre les étapes C) et D), de manière que des zones partielles de la couche miroir (3) soient enlevées.

7. Procédé selon l'une des revendications précédentes, comprenant, après l'étape F), le grainage de la couche semi-conductrice structurée (2) en tant qu'étape supplémentaire J1).

8. Procédé selon la revendication 7,
comprenant, en tant qu'étape supplémentaire J2) après l'étape J1), le revêtement de la couche semi-conductrice rugueuse (2) par une couche de finition (10) transparente au rayonnement visible, au rayonnement UV, au rayonnement IR ou à une combinaison de ces rayonnements et contenant du bisbenzocyclobutène.

9. Procédé selon la revendication 8,
comprenant, en tant qu'étape supplémentaire J3) après l'étape J2), la structuration de la couche de finition (10).

10. Procédé selon la revendication 9,
comprenant, en tant qu'étape supplémentaire J4) après l'étape J3), l'application d'un contact électrique (11) sur une zone partielle de la couche semi-conductrice (2) exposée de nouveau à la suite de la structuration de la couche de finition (10).

11. Procédé selon l'une des revendications précédentes,
les structures de la couche miroir (3) appliquée à l'étape C) s'étendant jusqu'à la couche semi-conductrice (2).

12. Composant optoélectronique comprenant :
- une couche semi-conductrice structurée (2),
- un diélectrique structuré à faible réfraction (16) déposé sur la couche semi-conductrice (2),
- une couche miroir métallique (3) disposée sur la couche semi-conductrice (2) et le diélectrique à faible réfraction (16), la face de la couche miroir métallique (3) tournée vers la couche semi-conductrice (2) présentant des structures,
- une couche barrière de diffusion (4) disposée sur la couche miroir métallique (3),
la couche semi-conductrice (2) présentant des tranchées mesa (12) dotées d'un flanc mesa positif (13), les tranchées mesa (12) se rétrécissant depuis une surface libre de la couche semi-conductrice (2) vers la couche miroir (3),
- une couche de passivation (5) disposée sur la couche barrière de diffusion (4), et
- une couche de contact électrique (8) disposée sur ladite couche de passivation (5).

13. Composant optoélectronique selon la revendication 12, comprenant :
- un disque support (9), la couche de contact (8) étant disposée sur le disque support (9),
- une couche barrière (7) disposée sur ladite couche de contact (8),
- une couche adhésive (6) disposée sur ladite couche barrière (7),
la couche adhésive (6) étant liée à la couche de passivation (5) .
